Europäisches Patentamt

European Patent Office

Office européen des brevets

(19)

(11) Publication number: **0 084 464**
A2

(12) **EUROPEAN PATENT APPLICATION**

(21) Application number: **83300291.8**

(22) Date of filing: **20.01.83**

(51) Int. Cl.³: **H 01 L 23/48**
**H 01 L 21/60**

(30) Priority: **20.01.82 US 340964**

(43) Date of publication of application:
**27.07.83 Bulletin 83/30**

(84) Designated Contracting States:
**BE CH DE FR GB IT LI NL SE**

(71) Applicant: **NORTH AMERICAN SPECIALITIES CORP.**
**120-12 28th Avenue**
**Flushing New York 11354(US)**

(72) Inventor: **Seidler, Jack**
**59-40 157 Street**
**Flushing New York 11355(US)**

(74) Representative: **Warren, Keith Stanley et al,**
**BARON & WARREN 18 South End Kensington**
**London W8 5BU(GB)**

(54) Connector for electronic subassemblies.

(57) A connector for electronic subassemblies is initially formed as a small sphere having an outer coating of solder (2), for example 1.0mm in diameter, and an inner core (4) of copper, for example 0.5mm in diameter. To effect a connection, the connector is positioned between an electrical bonding pad (16) of an integrated circuit chip (12) and an interconnect pattern (14) on a ceramic substrate (10), and is then heated so that the solder (2) flows, making mechanical and electrical contact to the pad and interconnect pattern on the chip and substrate. The copper (4) core does not melt and maintains a predetermined space, between the chip (12) and substrate (10).

FIG. 2

Croydon Printing Company Ltd

CONNECTOR FOR ELECTRONIC SUBASSEMBLIES

The invention relates generally to electronic components and particularly to spacing and attachment between two small components such as an integrated circuit chip and a ceramic base in a flip chip configuration.

In the fabrication of electronic subassemblies, for example, integrated circuits, an integrated circuit chip is mechanically and electrically attached to a larger ceramic substrate. The chip has electrical connection pads formed at various locations on one of its faces. The ceramic substrate also has an interconnect pattern with connection pads on one of its faces. In one technique solder is positioned between the pads on the chip and the ports on the ceramic substrate and connection is made by melting the solder. Spacers, either spherical or square, may also be included in the connection to keep proper standoff or space between the chip and substrate.

In the U.S. Patent 3,488,840, there is disclosed a process for joining a microminaturized circuit element (chip) to a microelectronic circuit (substrate), with the chip being positively spaced from the substrate. A copper ball (called in that patent a terminal element) is first placed adjacent a solder layer on the chip. Then it is heated, and solder flows around the adjacent part of the ball. The chip is then flipped over with the ball being positioned adjacent to a new solder layer on the substrate. When heated, the new solder flows around the adjacent part of the ball. The two solders are different and the melting points of the two solders must be different. This patent has the solder initially both on the chip and the substrate, and there is no solder initially on the ball. U.S. Patent 3,871,015 is similar and shows a method of joining a chip to a substrate with interconnectors of solder and copper. U.S. Patent 3,470,611 discloses a semiconductor device assembly method wherein solder coated contacts are formed onto a semiconductor chip. Copper pillars are directly mounted on the chip and are covered with a semicircular dot of solder. When heated, the solder makes the connection and the copper pillar provides standoff. These three patents identify and examine some of the technical problems and advantages of this type of connection: -- (a) preventing the solder from collapsing during the heat joining step, and (b) mechanical flexability and rigidity. The '015 patent discusses the prior art, and some of the short comings in the prior art.

The earlier prior art shows a solder ball which is completely of solder. During the heating-joining step, the solder balls tend to collapse completely, and thus produce insufficient space between the chip and substrate. Applicant notes that rigid balls such as copper, when previously used in the prior art have been uncoated with solder and thus have required the application of solder to the chip and substrate faces to provide necessary solder for the connection; alternately the prior art mounted a pillar directly on the substrate, and then coated it with solder.

A preferred embodiment of the present invention is the provision of a solder ball having a core of copper, (for example, approximately 0.5mm in diameter), and an outer core of solder, (for example, 1.0mm indiameter). The inner core need not be copper, but any material having a higher melting point than the solder; and thus will not deform during the heating and flowing of the solder.

The solder balls of the present invention should be much easier to manufacture than the prior art techniques of depositing the solder on the chips and/or substrate, and there should follow a resultant economy and ease of manufacture. It would also achieve the desired feature of positive standoff or separations between the chip and substrate, which is important, not only to prevent electrical difficulties during manufacture, but also to permit cleaning of the space between the chip and substrate.

These and other features and advantages of the invention will become more apparent from the detailed description which follows.

According to one aspect of the invention, there is provided a connector for attaching and spacing a microelectronic component to a base. It has an inner core, and an outer layer of solder surrounding said inner core; and the inner core has a higher melting point than the solder.

In the accompanying drawings:-

FIG. 1 is a cross-sectional view of a solder ball of the invention.

FIG. 2 is a cross-sectional view showing the solder ball of the invention connected to an electronic subassembly.

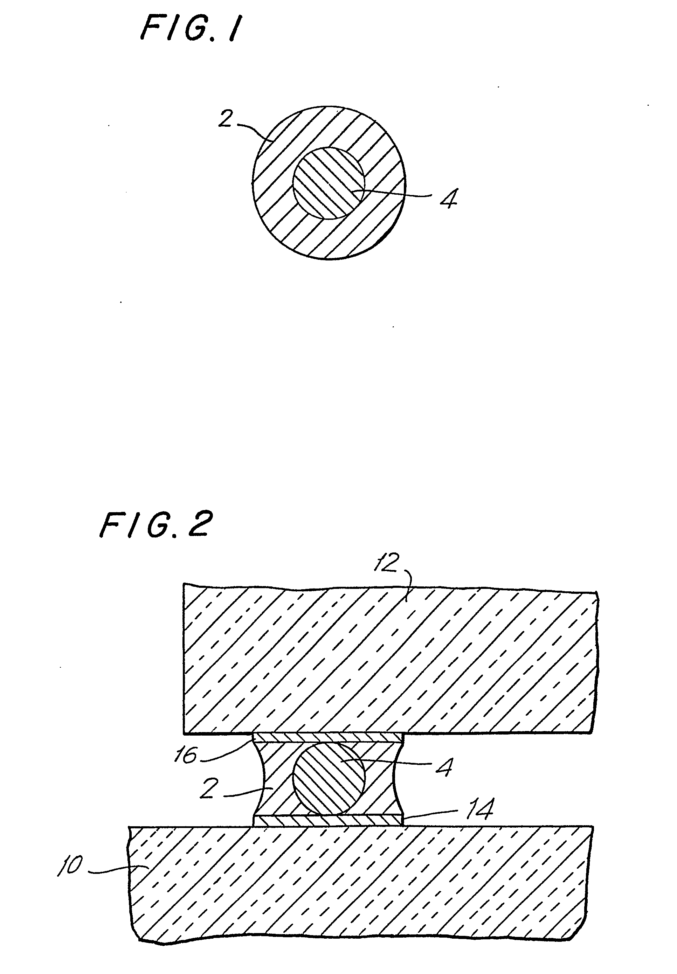

In FIG. 1, there is shown in cross-section a sphere having an outer coating of solder 2 and an inner core of copper 4. The outside diameter of the sphere is 1.0mm, and the diameter of the copper sphere is 0.5mm.

The spheres are easily manufacturable. The copper ball is first fabricated and then the solder is applied outside by electroplating, dipping, or any other convenient or conventional method.

In FIG. 2, there is shown a ceramic base or substrate 10, and a facing electronic component, for example, an integrated circuit chip 12. An electrical interconnect pattern or connection pad 14 and 16 are on facing surfaces of the substrate and chip respectively. The solder ball is inbetween. In FIG. 2, the solder has been melted, and has flowed and makes contact with the electrical contacts 14 and 16. The core 4 does not melt during the heating and flowing of the solder, and thus provides mechanical separation or standoff between the substrate 10 and chip 12.

The solder balls are first melted onto the ceramic base 10 and 14. The component 12 is then placed atop, positioned, (the subassembly may be flipped over), and heat is again applied, and the solder flows to the pad region 16. An advantage here is that there is a fixed standoff of the core 4, (in the example, 0.5mm), which amongst other things enables flux to be easily cleaned.

In the preferred embodiment, copper is used for the core 4. Any conductive metal may be used, provided it has a higher melting point than that of solder, (and which is compatible with the materials over the usable life of the electronic device).

In the example, a solder ball having a particular dimension has been described. It is envisioned that solder balls both larger and smaller might be used, as well as with thinner or thicker solder layers.

It will be noted that in the present invention the solder initially completely surrounds the core. When heated, the solder collapses and flows to the adjacent surfaces still leaving the core in the center of the flow. Thus, good mechanical standoff between the two parts in achieved, as well as mechanical adhesion between the two parts. If the adjacent surfaces are electrically conducting, e.g. there is an electrical conducting pad or interconnect pattern, the solder will provide a conduction electrical connection thereto. The standoff however, may be also used just to provide standoff and mechanical connection which has no electrical connections. This would achieve the goal of mechanical spacing without electrical conduction. The electrical component 12 need not be a integrated circuit, but may be any component, and the substrate may be an electrical component.

## CLAIMS

1. A connector for attaching and spacing a microelectronic component (12) to a base (10), characterised by an inner core (4) and an outer layer (2) of solder surrounding said inner core, said inner core having a higher melting point than said solder.

2. A connector according to claim 1, characterised in that the inner core (4) is an electrically conductive material.

3. A connector according to claim 2, characterised in that the core (4) is copper.

4. A connector according to claim 1, 2 or 3, characterised in that the inner core (4) is a sphere and the outer layer (2) is of uniform thickness.

5. A connector according to claim 4, characterised in that the core (4) is about one-half millimeter in diameter and the outer layer (2) has an outside diameter of approximately one millimeter.

6. A connector according to claim 4, characterised in that the core (4) has a diameter of less than one-half millimeter.

7. A connector according to claim 4 or 6, characterised in that the outer layer (2) has a diameter of less than one millimeter.

8. An electronic module comprising two members (10,12) facing each other and spaced apart from each other, one or more pairs of connection locations (14,16) on the members facing each other, and a connector between the or each of said pairs of connection locations, characterised in that the connector has a central core (4) surrounded by solder (2), said central core has a higher melting point than said solder, said solder is flowed onto the associated facing pair of connection locations (14,16), and said solder is of uniform composition between said facing connection locations.

9.       A module according to claim 8, characterised in that the core (4) is a sphere approximately one-half millimeter in diameter.

10.       A module according to claim 8 or 9, characterised in that the core (4) is made of copper or other electrically conductive material.

*FIG. 1*

*FIG. 2*